# EUROPEAN PATENT APPLICATION

(11) **EP 2 096 689 A1**
(43) Date of publication of application: **02.09.2009**
(21) Application number: 07831895.3
(22) Date of filing: 15.11.2007
(51) Int. Cl.: H01L 43/08, G01R 33/09, G11B 5/39, H01F 10/30, H01F 10/32, H01L 43/12

(54) **MAGNETORESISTANCE EFFECT ELEMENT, MAGNETIC SENSOR AND METHOD FOR MANUFACTURING MAGNETORESISTANCE EFFECT ELEMENT**

(30) Priority: 17.11.2006 JP 2006311199
(71) Applicant: Alps Electric Co., Ltd., Ota-ku Tokyo 145-8501 (JP)
(72) Inventor: SUGIHARA, Shinji, Tokyo 145-8501 (JP); ANDO, Hideto, Tokyo 145-8501 (JP); SASAKI, Shinichi, Tokyo 145-8501 (JP); SEINO, Takuya, Tokyo 145-8501 (JP)
(74) Representative: Klunker . Schmitt-Nilson . Hirsch
(86) International application number: PCT/JP2007/072165
(87) International publication number: WO 2008/059913

(57) **Abstract**

[Object] It is an object to provide a magnetoresistive element in which the interlayer coupling magnetic field Hin can be controlled to be 10 (Oe) or more and the variation in the interlayer coupling magnetic field Hin can be reduced by adjusting not only the thickness of a Cu film but also the thickness of an IrMn film, and a magnetic sensor including the magnetoresistive element.

[Solving Means] The thickness of an IrMn film and the thickness of a Cu film are adjusted so as to be within the area surrounded by boundaries a to f on the graph of Fig. 6 in which the horizontal axis represents the IrMn film thickness and the vertical axis represents the Cu film thickness. Consequently, the interlayer coupling magnetic field Hin can be made to be 10 (Oe) or more, and the variation in the interlayer coupling magnetic field Hin can be made to be 2 (Oe) or less. In addition, in the area surrounded by boundaries a to f, at any IrMn film thickness, the Cu film thickness range in which the variation can be made to be 2 Oe or less can be set over a wide range, as compared with a known structure.

## Description

### Technical Field

The present invention relates to magnetoresistive elements used in magnetic sensors, and in particular, to a magnetoresistive element which has an interlayer coupling magnetic field Hin of 10 (Oe) or more and in which the variation in the interlayer coupling magnetic field Hin can be reduced, a magnetic sensor including the magnetoresistive element, and a method of producing the magnetoresistive element.

### Background Art

Magnetoresistive elements are used in thin-film magnetic heads installed in hard disk drives, as disclosed in Patent Documents 1 to 3, and in magnetic sensors installed in, for example, mobile phones, as disclosed in Patent Document 4.

A Hall element and other elements have been used in magnetic sensors. However, use of a magnetoresistive element, which can detect a magnetic field even when an external magnetic field is relatively weak, which is stable against environmental changes, and in which a long lifetime can be expected has been attracting attention.

In a thin-film magnetic head installed in a hard disk drive, the interlayer coupling magnetic field Hin acting between a pinned magnetic layer and a free magnetic layer both of which constitute a magnetoresistive element is adjusted to be 0 (Oe).

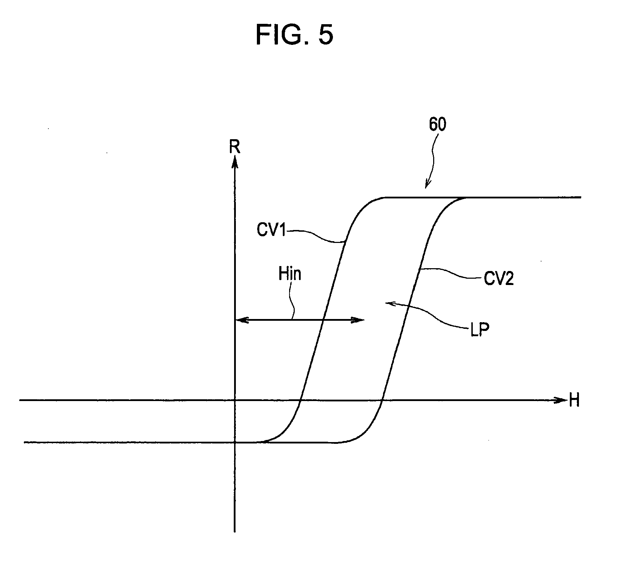

On the other hand, in the magnetic sensor, the interlayer coupling magnetic field Hin shown in Fig. 5 is set to be a value larger than 0 (Oe), and a magnetoresistive element showing an R-H curve with hysteresis is used.

The magnetoresistive element showing the above R-H curve is used in a magnetic sensor. For example, such a magnetoresistive element is provided on the display unit side of a foldable mobile phone, and a magnet is provided on the operating unit side. While the foldable mobile phone is being folded, the magnet approaches the magnetoresistive element, and consequently, an external magnetic field acting on the magnetoresistive element gradually increases. When a certain magnitude or more of an external magnetic field enters the magnetoresistive element, the electrical resistance of the magnetoresistive element starts to change. An integrated circuit outputs a magnetic-field detection signal on the basis of the change in the resistance of the magnetoresistive element, and thus, the opening and closing of the foldable mobile phone can be discriminated.
Patent Document 1: Japanese Unexamined Patent Application Publication No. 2000-215417
Patent Document 2: Japanese Unexamined Patent Application Publication No. 2002-208120
Patent Document 3: Japanese Unexamined Patent Application Publication No. 2000-332318
Patent Document 4: Japanese Unexamined Patent Application Publication No. 2006-266777

### Disclosure of Invention

### Problems to be Solved by the Invention

As described in page 180 of "DESIGN AND ANALYSIS OF MAGNETORESISTIVE RECORDING HEADS" written by EDGAR M. WILLIAMS (A Wiley-Interscience Publication, issued in 2001), it is known that the interlayer coupling magnetic field Hin is changed by changing the thickness of a copper (Cu) film provided between a free magnetic layer and a pinned magnetic layer of a magnetoresistive element.

Accordingly, hitherto, in a magnetoresistive element used for a magnetic sensor, the interlayer coupling magnetic field Hin has been adjusted by adjusting the thickness of the Cu film.

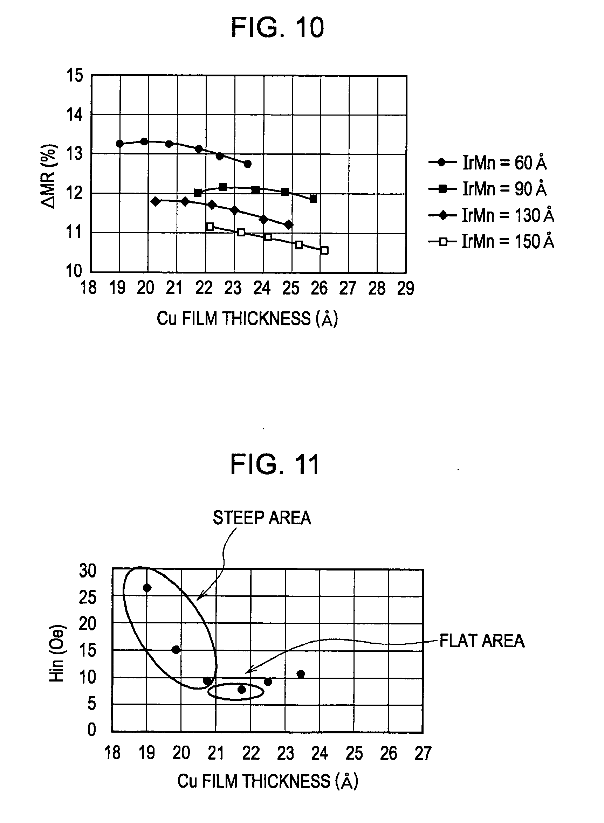

Fig. 11 is a graph showing the relationship between the thickness of a Cu film and the interlayer coupling magnetic field Hin. The film structure used in the experiment is, from the bottom, substrate/seed layer; NiFeCr (42)/antiferromagnetic layer; IrMn (60)/pinned magnetic layer; [Fe_{30at%}CO_{70at%} (14)/Ru (8.7)/Co_{90at%}Fe_{10at%} (20)]/nonmagnetic interlayer; Cu (X)/free magnetic layer [Co_{90at%}Fe_{10at%} (10)/Ni_{80at %}Fe_{20at%} (30)]/Ta (30). Note that each of the numbers in parentheses represents the film thickness and is given in units of Å.

In the experiment, the magnetization direction of the pinned magnetic layer in the above film structure is pinned in a predetermined direction by annealing in a magnetic field under the conditions of an annealing temperature of 270°C, an annealing time of 1.5 hours, and a magnetic field of 15 kOe.

As shown in Fig. 11, it was found that, as the thickness of the Cu film was decreased, the interlayer coupling magnetic field Hin markedly increased after a threshold Cu film thickness of about 21.5 Å.

As shown in Fig. 11, when the thickness of the Cu film is in the range of about 21 to 23 Å, variation in the interlayer coupling magnetic field Hin could be reduced, but the interlayer coupling magnetic field Hin is less than 10 (Oe).

On the other hand, when the thickness of the Cu film is set to be 21 Å or less, the interlayer coupling magnetic field Hin markedly increased, and thus, an interlayer coupling magnetic field Hin of 10 (Oe) or more could be easily realized. However, when the thickness of the Cu film is set to be 21 Å or less, the interlayer coupling magnetic field Hin significantly varied even in the case where the thickness of the Cu film is slightly changed. More specifically, as shown in Fig. 11, when the thickness of the Cu film is changed by only about 1 Å, the interlayer coupling magnetic field Hin varied by about 5 to 10 (Oe). Accordingly, the variation in the interlayer coupling magnetic field Hin is large relative to the change in the Cu film thickness.

When the variation in the interlayer coupling magnetic field Hin is large, an R-H curve 60 shown in Fig. 5 significantly varies on the horizontal axis, which represents the external magnetic field, in the horizontal direction of the drawing. Such a variation in the R-H curve 60 indicates that, in magnetic sensors, the output timing of a magnetic-field detection signal in response to a change in the intensity of the external magnetic field varies. Such a variation in the output timing causes a problem in terms of quality. It is thus important that the above-described variation in the interlayer coupling magnetic field Hin be suppressed in order to suppress the output variation.

In this respect, as shown in Fig. 11, in order to suppress the variation in the interlayer coupling magnetic field Hin to, for example, 2 (Oe) or less in the range where an interlayer coupling magnetic field Hin of 10 (Oe) or more can be achieved, the Cu film should be deposited with high accuracy such that an acceptable error range of the thickness of the Cu film is less than 1 Å.

However, in reality, considering an error in film deposition, it is impossible that the error range of the thickness of the Cu film is reduced to 1 Å or less. Accordingly, hitherto, the thicknesses in the "steep area" shown in Fig. 11 cannot be used, and only the thicknesses in the "flat area" have been used in which the interlayer coupling magnetic field Hin is lower than 10 (Oe) and the variation in the interlayer coupling magnetic field Hin relative to the change in the Cu film thickness is small.

In the above case, although the variation in the interlayer coupling magnetic field Hin relative to the change in the Cu film thickness can be suppressed, the interlayer coupling magnetic field Hin of the magnetoresistive element is less than 10 (Oe), and thus, the electrical resistance of the magnetoresistive element readily changes in response to a slight change in an external magnetic field. In this case, a problem occurs when a disturbance magnetic field, which becomes a cause of noise other than the external magnetic field generated by a magnet, acts on the magnetoresistive element. When the resistance of the magnetoresistive element is changed by the disturbance magnetic field, noise is generated, and thus the operational stability is decreased. Accordingly, it is preferable that the interlayer coupling magnetic field Hin be set to be 10 (Oe) or more.

The present invention has been conceived in order to solve the above problems of the related art. In particular, the present invention provides a magnetoresistive element in which the interlayer coupling magnetic field Hin can be controlled to be 10 (Oe) or more and the variation in the interlayer coupling magnetic field Hin can be reduced by adjusting not only the thickness of a Cu film but also the thickness of an IrMn film, a magnetic sensor including the magnetoresistive element, and a method of producing the magnetoresistive element.

### Means for Solving the Problems

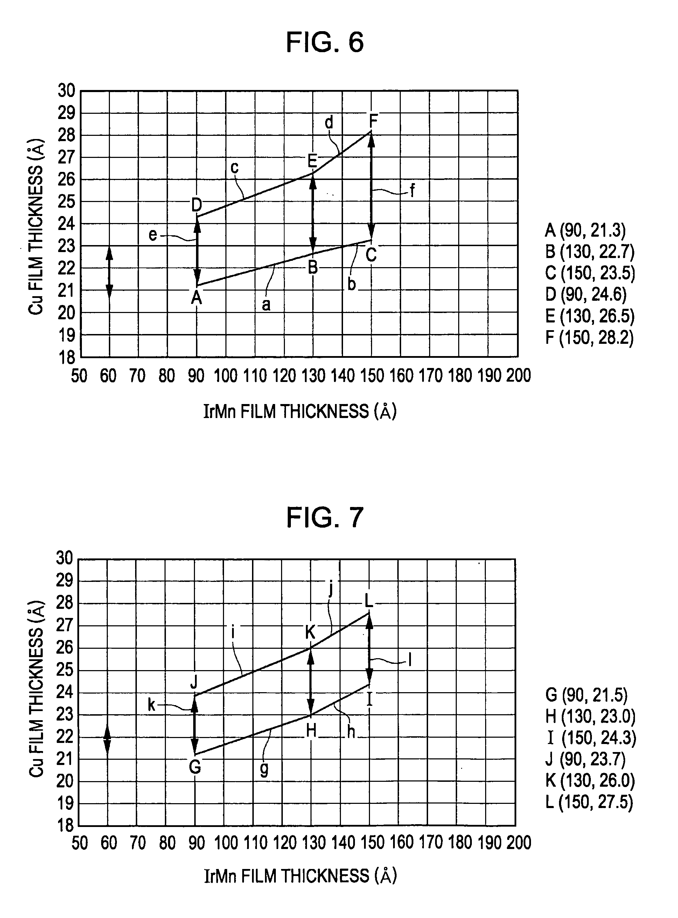

The present invention provides a magnetoresistive element used in a magnetic sensor, having a laminated structure including an antiferromagnetic layer, a pinned magnetic layer which is provided on the antiferromagnetic layer and in which the magnetization direction is pinned, and a free magnetic layer which faces the pinned magnetic layer with a nonmagnetic interlayer provided therebetween and in which the magnetization direction changes in response to an external magnetic field,
wherein the antiferromagnetic layer is composed of IrMn, and the nonmagnetic interlayer is composed of Cu, and
wherein the thickness of the antiferromagnetic layer and the thickness of the nonmagnetic interlayer have values that are within the area surrounded by, on a graph of Fig. 6 in which the horizontal axis represents the IrMn film thickness and the vertical axis represents the Cu film thickness,
boundary a (including points on boundary a) formed by a straight line joining point A (IrMn film thickness, Cu film thickness) = (90 Å, 21.3 Å) and point B (IrMn film thickness, Cu film thickness) = (130 Å, 22.7 Å),
boundary b (including points on boundary b) formed by a straight line joining the point B and point C (IrMn film thickness, Cu film thickness) = (150 Å, 23.5 Å),
boundary c (including points on boundary c) formed by a straight line joining point D (IrMn film thickness, Cu film thickness) = (90 Å, 24.6 Å) and point E (IrMn film thickness, Cu film thickness) = (130 Å, 26.5 Å),
boundary d (including points on boundary d) formed by a straight line joining the point E and point F (IrMn film thickness, Cu film thickness) = (150 Å, 28.2 Å),
boundary e (including points on boundary e) formed by a straight line joining the point A and the point D, and
boundary f (including points on boundary f) formed by a straight line joining the point C and the point F.

In the present invention, by adjusting the thickness of the antiferromagnetic layer (IrMn) and the thickness of the nonmagnetic interlayer (Cu) so as to be within the area surrounded by boundaries a to f defined above, the interlayer coupling magnetic field Hin can be made to be 10 (Oe) or more, and the variation in the interlayer coupling magnetic field Hin can be made to be 2 (Oe) or less. In addition, in the area surrounded by boundaries a to f, at any IrMn film thickness, the Cu film thickness range in which the variation can be made to be 2 (Oe) or less can be set over a wide range, as compared with a known structure.

A feature of the present invention lies in the fact that not only the Cu film thickness but also the IrMn film thickness is adjusted at the same time. Specificity, hitherto, the adjustment of the interlayer coupling magnetic field Hin has been performed by adjusting the Cu film thickness. However, the inventors of the present invention have found that the IrMn film thickness is also related to the interlayer coupling magnetic field Hin and determined the above area on the basis of experiments. In the area surrounded by boundaries a to f, at any IrMn film thickness, when the Cu film thickness is changed within an acceptable range at the IrMn film thickness, the difference between the maximum value of the interlayer coupling magnetic field Hin and the minimum value (bottom value) of the interlayer coupling magnetic field Hin is 2 (Oe) or less. As described above, in the present invention, the acceptable range of the Cu film thickness in which the variation can be made to be 2 (Oe) or less can be set over a wide range, as compared with a known structure. Accordingly, even if a certain degree of error in film deposition is present, a magnetoresistive element which has an interlayer coupling magnetic field Hin of 10 (Oe) or more and a variation in the interlayer coupling magnetic field Hin of 2 (Oe) or less can be appropriately and easily obtained.

In the present invention, more preferably, the thickness of the antiferromagnetic layer and the thickness of the nonmagnetic interlayer have values that are within the area surrounded by, on a graph of Fig. 7 in which the horizontal axis represents the IrMn film thickness and the vertical axis represents the Cu film thickness,
boundary g (including points on boundary g) formed by a straight line joining point G (IrMn film thickness, Cu film thickness) = (90 Å, 21.5 Å) and point H (IrMn film thickness, Cu film thickness) = (130 Å, 23.0 Å),
boundary h (including points on boundary h) formed by a straight line joining the point H and point I (IrMn film thickness, Cu film thickness) = (150 Å, 24.3 Å),
boundary i (including points on boundary i) formed by a straight line joining point J (IrMn film thickness, Cu film thickness) = (90 Å, 23.7 Å) and point K (IrMn film thickness, Cu film thickness) = (130 Å, 26.0 Å),
boundary j (including points on boundary j) formed by a straight line joining the point K and point L (IrMn film thickness, Cu film thickness) = (150 Å, 27.5 Å),
boundary k (including points on boundary k) formed by a straight line joining the point G and the point J, and
boundary l (including points on boundary l) formed by a straight line joining the point I and the point L. Consequently, the interlayer coupling magnetic field Hin can be made to be 10 (Oe) or more, and the variation in the interlayer coupling magnetic field Hin can be made to be 1 (Oe) or less. In addition, in the area surrounded by boundaries g to l, at any IrMn film thickness, the range of the Cu film thickness in which the variation can be made to be 1 (Oe) or less can be set over a wide range, as compared with a known structure. Accordingly, even if a certain degree of error in film deposition is present, a magnetoresistive element which has an interlayer coupling magnetic field Hin of 10 (Oe) or more and a variation in the interlayer coupling magnetic field Hin of 1 (Oe) or less can be appropriately and easily obtained.

A magnetic sensor in the present invention includes the magnetoresistive element described above and an integrated circuit which is connected to the magnetoresistive element and which generates and outputs a magnetic-field detection signal on the basis of a change in the electrical resistance of the magnetoresistive element in response to an external magnetic field.

Accordingly, a magnetic sensor which is not significantly affected by a disturbance magnetic field, which has excellent operational stability, and in which the variation in the output timing of the magnetic-field detection signal is reduced can be obtained.

In the present invention, two of the magnetoresistive elements are preferably provided, and the magnetoresistive elements preferably constitute a bridge circuit together with fixed resistance elements whose electrical resistances do not change in response to the external magnetic field. In such a bridge circuit structure, the output can be doubled by a differential output, and magnetic field detection can be performed with high accuracy. In the present invention, two of the magnetoresistive elements may be provided, and each of the magnetoresistive elements can be formed so as to have an interlayer coupling magnetic field Hin of 10 (Oe) or more and a small variation in the interlayer coupling magnetic field Hin. Consequently, magnetic field detection can be performed with excellent operational stability.

According to the present invention, in a method of producing a plurality of magnetoresistive elements used in a magnetic sensor on a single substrate by the same film deposition process, the magnetoresistive elements are formed so as to have a laminated structure including an antiferromagnetic layer, a pinned magnetic layer which is provided on the antiferromagnetic layer and in which the magnetization direction is pinned, and a free magnetic layer which faces the pinned magnetic layer with a nonmagnetic interlayer provided therebetween and in which the magnetization direction changes in response to an external magnetic field.

In this case, the thickness of the antiferromagnetic layer and the thickness of the nonmagnetic interlayer have values that are within the area surrounded by, on a graph of Fig. 6 in which the horizontal axis represents the IrMn film thickness and the vertical axis represents the Cu film thickness,
boundary a (including points on boundary a) formed by a straight line joining point A (IrMn film thickness, Cu film thickness) = (90 Å, 21.3 Å) and point B (IrMn film thickness, Cu film thickness) = (130 Å, 22.7 Å),
boundary b (including points on boundary b) formed by a straight line joining the point B and point C (IrMn film thickness, Cu film thickness) = (150 Å, 23.5 Å),
boundary c (including points on boundary c) formed by a straight line joining point D (IrMn film thickness, Cu film thickness) = (90 Å, 24.6 Å) and point E (IrMn film thickness, Cu film thickness) = (130 Å, 26.5 Å),
boundary d (including points on boundary d) formed by a straight line joining the point E and point F (IrMn film thickness, Cu film thickness) = (150 Å, 28.2 Å),
boundary e (including points on boundary e) formed by a straight line joining the point A and the point D, and
boundary f (including points on boundary f) formed by a straight line joining the point C and the point F.

By adjusting the thickness of the antiferromagnetic layer (IrMn) and the thickness of the nonmagnetic interlayer (Cu) so as to be within the area surrounded by boundaries a to f defined above, the interlayer coupling magnetic field Hin can be made to be 10 (Oe) or more, and the variation in the interlayer coupling magnetic field Hin can be made to be 2 (Oe) or less. In addition, in the area surrounded by boundaries a to f, at any IrMn film thickness, the Cu film thickness range in which the variation can be made to be 2 (Oe) or less can be set over a wide range, as compared with a known structure.

Accordingly, when a plurality of magnetoresistive elements are formed on a single substrate by the same film deposition process, even in the case where an error in film deposition is present, the magnetoresistive elements can be easily and appropriately produced so that the interlayer coupling magnetic field Hin of each of the magnetoresistive elements is 10 (Oe) or more and the variation in the interlayer coupling magnetic field Hin is 2 (Oe) or less, and the yield can also be improved.

Furthermore, in the present invention, the thickness of the antiferromagnetic layer and the thickness of the nonmagnetic interlayer have values that are within the area surrounded by, on a graph of Fig. 7 in which the horizontal axis represents the IrMn film thickness and the vertical axis represents the Cu film thickness,
boundary g (including points on boundary g) formed by a straight line joining point G (IrMn film thickness, Cu film thickness) = (90 Å, 21.5 Å) and point H (IrMn film thickness, Cu film thickness) = (130 Å, 23.0 Å),
boundary h (including points on boundary h) formed by a straight line joining the point H and point I (IrMn film thickness, Cu film thickness) = (150 Å, 24.3 Å),
boundary i (including points on boundary i) formed by a straight line joining point J (IrMn film thickness, Cu film thickness) = (90 Å, 23.7 Å) and point K (IrMn film thickness, Cu film thickness) = (130 Å, 26.0 Å),
boundary j (including points on boundary j) formed by a straight line joining the point K and point L (IrMn film thickness, Cu film thickness) = (150 Å, 27.5 Å),
boundary k (including points on boundary k) formed by a straight line joining the point G and the point J, and
boundary l (including points on boundary l) formed by a straight line joining the point I and the point L. Advantages

In the present invention, the thickness of an IrMn film and the thickness of a Cu film are adjusted so as to be within the area surrounded by boundaries a to f. Consequently, the interlayer coupling magnetic field Hin can be made to be 10 (Oe) or more, and the variation in the interlayer coupling magnetic field Hin can be made to be 2 (Oe) or less. In addition, in the area surrounded by boundaries a to f, at any IrMn film thickness, the Cu film thickness range in which the variation can be made to be 2 Oe or less can be set over a wide range, as compared with a known structure.

### Best Modes for Carrying Out the Invention

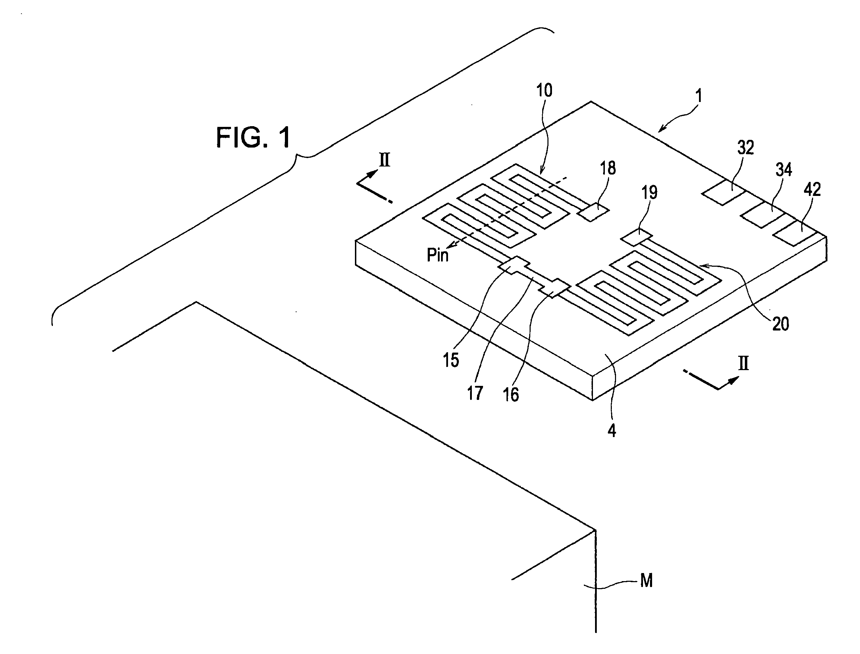

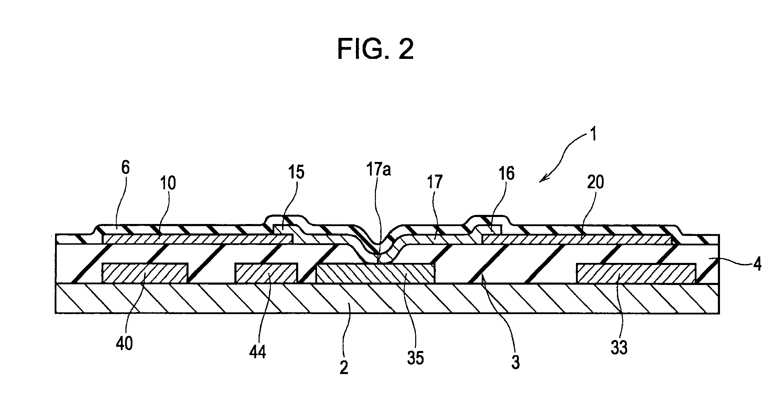

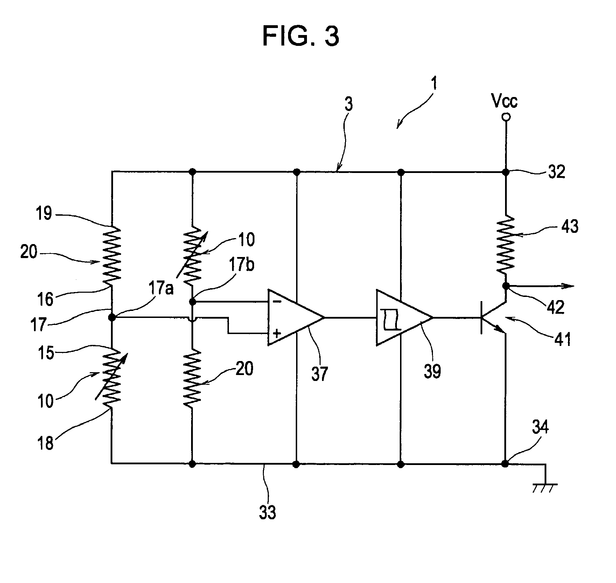

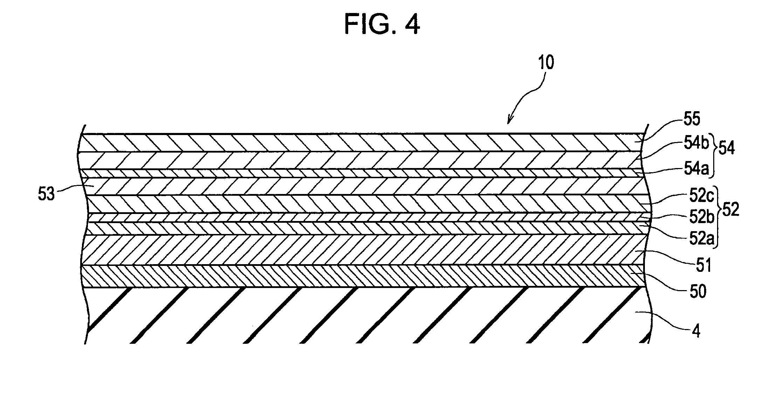

Fig. 1 is a perspective view showing a magnetic sensor of an embodiment. Fig. 2 is a longitudinal cross-sectional view of the magnetic sensor taken along line II-II of Fig. 1. Fig. 3 is a circuit configuration diagram of the magnetic sensor. Fig. 4 is an enlarged cross-sectional view showing the film structure of a magnetoresistive element (GMR element) of this embodiment cut along the film thickness direction. Fig. 5 is an R-H curve diagram of the magnetoresistive element of this embodiment.

In a magnetic sensor 1 shown in Fig. 1, a magnetoresistive element 10, a fixed resistance element 20, and an integrated circuit 3 are integrated to form a package, and thus the magnetic sensor 1 is configured to have a compact structure with a small thickness. When a magnetic-field-generating component such as a magnet M approaches the magnetic sensor 1, an ON output can be obtained. For example, this magnetic sensor 1 is installed in an operating unit of a foldable mobile phone on which key switches are arranged. The magnet M is installed in a display unit including a display device and the like. While the operating unit and the display unit are being folded, the magnet M approaches the magnetic sensor 1. When the operating unit and the display unit are in a folded state, an external magnetic field generated from the magnet M is detected by the magnetic sensor 1, and a magnetic-field detection signal (ON signal) is sent from the magnetic sensor 1.

As shown in Fig. 1, each of the magnetoresistive element 10 and the fixed resistance element 20 has a meander pattern in plan view so that the fundamental electrical resistance thereof is high.

In the embodiment shown in Fig. 1, a single magnetoresistive element 10 and a single fixed resistance element 20 are provided and are directly connected to each other via an output-extracting portion 17a. However, as shown in Fig. 3, two magnetoresistive elements 10 and two fixed resistance element 20 are preferably provided to form a bridge circuit.

As shown in Fig. 2, in the magnetic sensor 1 of this embodiment, the integrated circuit 3 including various types of active elements 33 and 40, such as a differential amplifier and a comparator, a wiring layer 35, a resistor 44, and the like is provided on a substrate 2 composed of silicon (Si).

The wiring layer 35 is composed of a low-resistance material, for example, aluminum.

The upper surface of the integrated circuit 3 is covered with an insulating layer 4. The insulating layer 4 has a laminated structure including, for example, a passivation layer covering the upper surface of the integrated circuit 3 and composed of, for example, silicon tetranitride (Si₃N₄), and a planarizing layer covering the upper surface of the passivation layer and composed of, for example, a resist having a planarized surface.

The magnetoresistive element 10 and the fixed resistance element 20 are formed on the insulating layer 4.

As shown in Fig. 1, an electrode layer 15 composed of a low-resistance material is provided at an end of the magnetoresistive element 10, and an electrode layer 18 also composed of a low-resistance material is provided at the other end of the magnetoresistive element 10. An electrode layer 16 composed of a low-resistance material is provided at an end of the fixed resistance element 20, and an electrode layer 19 also composed of a low-resistance material is provided at the other end of the fixed resistance element 20. The electrode layer 15 of the magnetoresistive element 10 is connected to the electrode layer 16 of the fixed resistance element 20 via a lead layer 17 so that the magnetoresistive element 10 and the fixed resistance element 20 are connected in series.

Furthermore, as shown in Fig. 2, the lead layer 17 penetrates through the insulating layer 4 and is connected to the upper surface of the wiring layer 35. The portion of the lead layer 17 connected to the wiring layer 35 serves as the output-extracting portion 17a.

As shown in Fig. 2, the upper surfaces of the magnetoresistive element 10 and the fixed resistance element 20 are protected by an insulating layer 6 composed of alumina (Al₂O₃), silicon dioxide (SiO₂), or the like. Furthermore, as shown in Fig. 1, a power supply pad 32, a ground pad 34, and an output pad 42 are exposed on the surface of the magnetic sensor 1.

As shown in Fig. 3, a power supply voltage Vcc is applied to the power supply pad 32, and the electric potential of the ground pad 34 is set to a ground potential. As shown in Fig. 3, when the magnetoresistive elements 10 and the fixed resistance element 20 constitute a bridge circuit, each of the output-extracting portions 17a and 17b of the bridge circuit is connected to a differential amplifier 37. The output voltage obtained from the bridge circuit is differentially amplified by the differential amplifier 37. This output is further sent to a Schmitt-trigger comparator 39 to be converted to rectangular waves from which noise has been removed. An output electric potential determined by an output transistor 41 and an output resistance 43 is supplied to the output pad 42 shown in Fig. 1.

When the magnetoresistive elements 10 and the fixed resistance elements 20 constitute a bridge circuit as shown in Fig. 3, the magnetoresistive elements 10 and the fixed resistance elements 20 are preferably formed on the same substrate. Alternatively, as shown in Fig. 1, a sensor portion may be composed of a single series circuit including a single magnetoresistive element 10 and a single fixed resistance element 20. However, the bridge circuit structure shown in Fig. 3 is preferable because the output can be twice that in the above case of a single series circuit, and thus the detection accuracy can be improved.

Next, the structure of the magnetoresistive element 10 will be described. As described above, the magnetoresistive element 10 is formed on the insulating layer 4 provided on the substrate 2 and having a planarized surface.

The magnetoresistive element 10 is formed by laminating, from the bottom, a seed layer 50, an antiferromagnetic layer 51, a pinned magnetic layer 52, nonmagnetic interlayer 53, a free magnetic layer 54, and a protective layer 55 in that order.

The seed layer 50 is composed of, for example, NiFeCr or Cr. The seed layer 50 is not necessarily formed. However, the formation of the seed layer 50 is preferable because the crystal orientation of each layer formed thereon can be improved.

The antiferromagnetic layer 51 is composed of an IrMn alloy. The composition ratio of Ir is preferably in the range of 10 to 80 atomic percent when the sum of the composition ratio of Ir and the composition ratio of Mn is 100 atomic percent.

In the embodiment shown in Fig. 4, the pinned magnetic layer 52 has a laminated ferrimagnetic structure. As shown in Fig. 4, the pinned magnetic layer 52 is formed by laminating, from the bottom, a first pinned magnetic sublayer 52a, a nonmagnetic conductive sublayer 52b, and a second pinned magnetic sublayer 52c, in that order.

Each of the first pinned magnetic sublayer 52a and the second pinned magnetic sublayer 52c is composed of a magnetic material such as a CoFe alloy, a NiFe alloy, or a CoFeNi alloy. The nonmagnetic conductive sublayer 52b is composed of a nonmagnetic conductive material such as Ru. When the first pinned magnetic sublayer 52a is composed of a CoFe alloy, the composition ratio of Co is preferably in the range of 20 to 100 atomic percent when the sum of the composition ratio of Co and the composition ratio of iron (Fe) is 100 atomic percent. When the second pinned magnetic sublayer 52c is composed of a CoFe alloy, the composition ratio of Co is preferably in the range of 10 to 100 atomic percent when the sum of the composition ratio of Co and the composition ratio of Fe is 100 atomic percent.

The first pinned magnetic sublayer 52a and the second pinned magnetic sublayer 52c are magnetized in antiparallel directions. Heat treatment in a magnetic field results in the generation of an exchange coupling magnetic field (Hex) between the first pinned magnetic sublayer 52a and the antiferromagnetic layer 51. In addition, the RKKY interaction is generated between the first pinned magnetic sublayer 52a and the second pinned magnetic sublayer 52c, and the magnetizations of the first pinned magnetic sublayer 52a and the second pinned magnetic sublayer 52c are pinned in antiparallel directions. Note that the "Pin" direction shown in Fig. 1 shows the magnetization direction of the second pinned magnetic sublayer 52c.

The pinned magnetic layer 52 may have a single-layer structure composed of a magnetic material or a laminated structure.

The nonmagnetic interlayer 53 is made of Cu.

The free magnetic layer 54 includes a soft magnetic sublayer 54b composed of, for example, a NiFe alloy and a diffusion-preventing sublayer 54a composed of, for example, a CoFe alloy, the diffusion-preventing sublayer 54a being disposed between the soft magnetic sublayer 54b and the nonmagnetic interlayer 53. The composition ratio of Ni of the NiFe alloy constituting the soft magnetic sublayer 54b is preferably in the range of 40 to 90 atomic percent when the sum of the composition ratio of Ni and the composition ratio of Fe is 100 atomic percent. The composition ratio of Co of the CoFe alloy constituting the diffusion-preventing sublayer 54a is preferably in the range of 20 to 100 atomic percent when the sum of the composition ratio of Co and the composition ratio of Fe is 100 atomic percent.

It is preferable that the fixed resistance element 20 be formed of layers composed of the same materials as those of the magnetoresistive element 10 shown in Fig. 4 and that the free magnetic layer 54 and the nonmagnetic interlayer 53 be laminated in the reverse order. This is because the resistance value of the fixed resistance element 20 can be set to be the same as that of the magnetoresistive element 10 and because a midpoint potential can be obtained from the output-extracting portions 17a and 17b when an external magnetic field do not act. When the free magnetic layer 54 and the nonmagnetic interlayer 53 are laminated in the reverse order, the pinned magnetic layer 52 is in direct contact with the free magnetic layer 54. Consequently, as in the pinned magnetic layer 52, the magnetization of the free magnetic layer 54 is pinned without being varied by an external magnetic field. Accordingly, the free magnetic layer 54 no longer functions as a free magnetic layer 54. As described above, by laminating the free magnetic layer 54 and the nonmagnetic interlayer 53 in the reverse order in the laminated structure shown in Fig. 4, the fixed resistance element 20 with a resistance value that is not changed by an external magnetic field can be formed.

The magnetoresistive element 10 of this embodiment shows an R-H curve 60 shown in Fig. 5. In the graph shown in Fig. 5, the horizontal axis represents an external magnetic field H, and the vertical axis represents the resistance value R of the magnetoresistive element 10. The R-H curve 60 preferably has a loop portion LP surrounded by a first curve CV1 and a second curve CV2.

The interlayer coupling magnetic field Hin acting between the pinned magnetic layer 52 and the free magnetic layer 54 of the magnetoresistive element 10 is defined by the intensity of a magnetic field from a line representing the external magnetic field H = 0 (Oe) to a midpoint of the loop portion LP. The extending width of the loop portion LP in the horizontal-axis direction at the intermediate value between the maximum resistance value and the minimum resistance value of the magnetoresistive element 10 (i.e., hysteresis) is defined as 2 × coercive force Hc. The central value of the extending width is the "midpoint" of the loop portion LP.

The magnetoresistive element 10 of this embodiment preferably has an interlayer coupling magnetic field Hin of 10 (Oe) or more. Here, 1 (Oe) is about 79 A/m.

The film thickness of the antiferromagnetic layer (IrMn) 51 (hereinafter referred to as "IrMn film thickness") and the thickness of the nonmagnetic interlayer (Cu) 52 (hereinafter referred to as "Cu film thickness"), these layers constituting the magnetoresistive element 10 of this embodiment, are adjusted so as to have values that are within the area surrounded by, on the graph of Fig. 6 in which the horizontal axis represents the IrMn film thickness and the vertical axis represents the Cu film thickness,
boundary a (including points on boundary a) formed by a straight line joining point A (IrMn film thickness, Cu film thickness) = (90 Å, 21.3 Å) and point B (IrMn film thickness, Cu film thickness) = (130 Å, 22.7 Å),
boundary b (including points on boundary b) formed by a straight line joining the point B and point C (IrMn film thickness, Cu film thickness) = (150 Å, 23.5 Å),
boundary c (including points on boundary c) formed by a straight line joining point D (IrMn film thickness, Cu film thickness) = (90 Å, 24.6 Å) and point E (IrMn film thickness, Cu film thickness) = (130 Å, 26.5 Å),
boundary d (including points on boundary d) formed by a straight line joining the point E and point F (IrMn film thickness, Cu film thickness) = (150 Å, 28.2 Å),
boundary e (including points on boundary e) formed by a straight line joining the point A and the point D, and
boundary f (including points on boundary f) formed by a straight line joining the point C and the point F.

As shown in Fig. 6, the IrMn film thickness is within the range of 90 Å to 150 Å. If the IrMn film thickness is less than 90 Å, it is impossible to widely set a range of the Cu film thickness in which an interlayer coupling magnetic field Hin of 10 (Oe) or more can be obtained with a small variation. An IrMn film thickness of more than 150 Å is not preferable because the ratio of change in resistance (ΔR/R) of the magnetoresistive element 10 is decreased, thereby degrading the detection accuracy.

A feature of this embodiment lies in the fact that the IrMn film thickness is adjusted as described above in order to obtain an interlayer coupling magnetic field Hin of 10 (Oe) or more. By selecting the IrMn film thickness and the Cu film thickness so as to be within the area surrounded by boundaries a to f shown in Fig. 6, the interlayer coupling magnetic field Hin can be made to be 10 (Oe) or more, and the variation in the interlayer coupling magnetic field Hin can be made to be 2 (Oe) or less. In addition, within the area surrounded by boundaries a to f described above, the Cu film thickness range in which the variation can be made to be 2 (Oe) or less at any IrMn film thickness can be set over a wide range, as compared with a known structure. Accordingly, even if a certain degree of error in film deposition is present, a magnetoresistive element which has an interlayer coupling magnetic field Hin of 10 (Oe) or more and a variation in the interlayer coupling magnetic field Hin of 2 (Oe) or less can be appropriately and easily obtained.

In this embodiment, more preferably, the IrMn film thickness and the Cu film thickness have values that are within the area surrounded by, on the graph of Fig. 7 in which the horizontal axis represents the IrMn film thickness and the vertical axis represents the Cu film thickness,
boundary g (including points on boundary g) formed by a straight line joining point G (IrMn film thickness, Cu film thickness) = (90 Å, 21.5 Å) and point H (IrMn film thickness, Cu film thickness) = (130 Å, 23.0 Å),
boundary h (including points on boundary h) formed by a straight line joining the point H and point I (IrMn film thickness, Cu film thickness) = (150 Å, 24.3 Å),
boundary i (including points on boundary i) formed by a straight line joining point J (IrMn film thickness, Cu film thickness) = (90 Å, 23.7 Å) and point K (IrMn film thickness, Cu film thickness) = (130 Å, 26.0 Å),
boundary j (including points on boundary j) formed by a straight line joining the point K and point L (IrMn film thickness, Cu film thickness) = (150 Å, 27.5 Å),
boundary k (including points on boundary k) formed by a straight line joining the point G and the point J, and
boundary l (including points on boundary l) formed by a straight line joining the point I and the point L. Thereby, the interlayer coupling magnetic field Hin can be made to be 10 (Oe) or more, and the variation in the interlayer coupling magnetic field Hin can be made to be 1 (Oe) or less. In addition, within the area surrounded by boundaries g to l described above, the Cu film thickness range in which the variation can be made to be 1 (Oe) or less at any IrMn film thickness can be set over a wide range, as compared with a known structure. Accordingly, even if a certain degree of error in film deposition is present, a magnetoresistive element which has an interlayer coupling magnetic field Hin of 10 (Oe) or more and a variation in the interlayer coupling magnetic field Hin of 1 (Oe) or less can be appropriately and easily obtained.

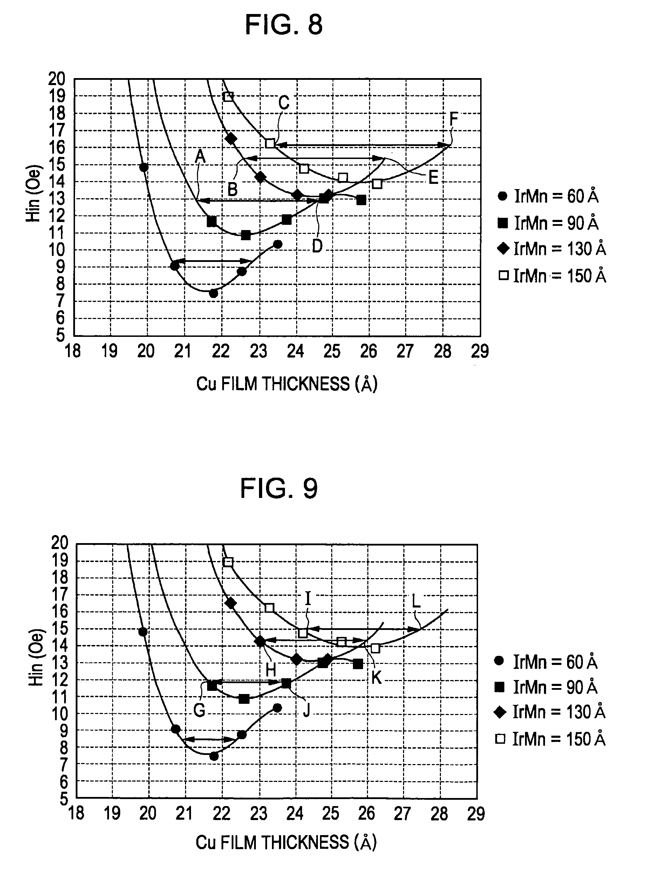

The points A to F shown in Fig. 6 and the points G to L shown in Fig. 7 were determined on the basis of experimental results shown in Figs. 8 and 9, respectively. The experiments shown in Figs. 8 and 9 will be described below.

In the experiments, magnetoresistive elements 10 were formed using laminates below.

The laminates used in the experiments had a structure of, from the bottom, substrate/seed layer; NiFeCr (42)/antiferromagnetic layer; Ir_{19at%}Mn_{81at%} (60 Å, 90 Å, 130 Å, or 150 Å)/pinned magnetic layer; [Fe_{30at%}Co_{70at%} (14)/Ru (8.7)/Co_{90at%}Fe_{10at%} (20)]/nonmagnetic interlayer; Cu (X)/free magnetic layer [Co_{90at%}Fe_{10at%} (10)/Ni_{80at%}Fe_{20at%} (30)]/Ta(30).

The laminates were annealed in a magnetic field under the conditions of an annealing temperature of 270°C, an annealing time of 1.5 hours, and a magnetic field intensity of 15 kOe so that the magnetization of the pinned magnetic layer was pinned in a predetermined direction.

In the experiments, the IrMn film thickness was varied to 60 Å (an example of a known structure), 90 Å, 130 Å, and 150 Å, and the Cu film thickness at each of the IrMn film thicknesses was further varied. In this manner, a plurality of magnetoresistive elements having different IrMn film thicknesses and different Cu film thicknesses were formed, and the interlayer coupling magnetic field Hin of each of the magnetoresistive elements was determined from the R-H curve 60 shown in Fig. 5. The experimental results are shown in Fig. 8.

As shown in Fig. 8, it was found that as the IrMn film thickness decreased, the minimum value (bottom value) of the interlayer coupling magnetic field Hin decreased. A range of the Cu film thickness in which the interlayer coupling magnetic field Hin was 2 (Oe) higher than the minimum value (bottom value) was determined for each of the IrMn film thicknesses. The range shown by a double-headed arrow in the horizontal-axis direction shows the above Cu film thickness range.

In the case where the IrMn film thickness was 60 Å (i.e., in the example of a known structure), the range of the Cu film thickness in which the interlayer coupling magnetic field Hin was 2 (Oe) higher than the minimum value (bottom value) was in the range of about 20.5 Å to 23 Å. That is, in the case where the IrMn film thickness was 60 Å, when the Cu film thickness was set to be in the range of 20.5 Å to 23 Å, the variation in the interlayer coupling magnetic field Hin can be reduced to 2 (Oe) or less.

However, as shown in Fig. 8, it was found that when the Cu film thickness was set to be in the range of 20.5 Å to 23 Å, the interlayer coupling magnetic field Hin was lower than 10 (Oe). On the other hand, as described with reference to Fig. 11, when the Cu film thickness was decreased, the interlayer coupling magnetic field Hin increased, and an interlayer coupling magnetic field Hin of 10 (Oe) or more could be obtained. However, in this case, even if the Cu film thickness slightly changed, the interlayer coupling magnetic field Hin significantly varied, causing a problem of an increase in the variation in the interlayer coupling magnetic field Hin relative to the change in the Cu film thickness. More specifically, the following was found: When the IrMn film thickness was set to be 60 Å and the Cu film thickness was 20.5 Å or less, an interlayer coupling magnetic field Hin of 10 Oe or more could be obtained. However, an acceptable error range of the Cu film thickness in which the variation in the interlayer coupling magnetic field Hin was reduced to 2 (Oe) or less was less than 1 Å.

Next, when the IrMn film thickness was 90 Å, the range of the Cu film thickness in which the interlayer coupling magnetic field Hin was 2 (Oe) higher than the minimum value (bottom value) was in the range of 21.3 Å to 24.6 Å. That is, in the case where the IrMn film thickness was 90 Å, when the Cu film thickness was set to be in the range of 21.3 Å to 24.6 Å, the variation in the interlayer coupling magnetic field Hin could be reduced to 2 (Oe) or less. In addition, it was found that the interlayer coupling magnetic field Hin was 11 (Oe) or more in this Cu film thickness range.

When the IrMn film thickness was 130 Å, the range of the Cu film thickness in which the interlayer coupling magnetic field Hin was 2 (Oe) higher than the minimum value (bottom value) was in the range of 22.7 Å to 26.5 Å. In addition, it was found that the interlayer coupling magnetic field Hin was 13 (Oe) or more in this Cu film thickness range.

When the IrMn film thickness was 150 Å, the range of the Cu film thickness in which the interlayer coupling magnetic field Hin was 2 (Oe) higher than the minimum value (bottom value) was in the range of 23.5 Å to 28.2 Å. In addition, it was found that the interlayer coupling magnetic field Hin was 14 (Oe) or more in this Cu film thickness range.

As described above, it was found that, when the IrMn film thickness was in the range of 90 Å to 150 Å, the Cu film thickness range in which the interlayer coupling magnetic field Hin was 10 (Oe) or more, and in which the difference between the maximum value of the interlayer coupling magnetic field Hi n and the minimum value of the interlayer coupling magnetic field Hin can be made to be 2 (Oe) or less at each IrMn film thickness when the Cu film thickness is changed, can be set over a wide range, as compared with the known structure. In the above example of a known structure in which the IrMn film thickness was 60 Å, when the Cu film thickness was set to be 20.5 Å or less, an interlayer coupling magnetic field Hin of 10 (Oe) or more could be realized. However, in order to reduce the variation in the interlayer coupling magnetic field Hin to 2 (Oe) or less, the acceptable range of the Cu film thickness was less than 1 Å. It was found that, in contrast, when the IrMn film thickness was in the range of 90 Å to 150 Å, the interlayer coupling magnetic field Hin could be made to be 10 (Oe) or more, and the range of the Cu film thickness in which the variation in the interlayer coupling magnetic field Hin could be made to be 2 (Oe) or less was at least 3 Å or more.

Next, points A to F shown in Fig. 8 were plotted on the graph shown in Fig. 6 in which the horizontal axis represents the IrMn film thickness and the vertical axis represents the Cu film thickness. Point A and point B were joined by a straight line forming boundary a, the point B and point C were joined by a straight line forming boundary b, point D and point E were joined by a straight line forming boundary c, the point E and point F were joined by a straight line forming boundary d, the point A and the point D were joined by a straight line forming boundary e, and the point C and the point F were joined by a straight line forming boundary f. Values that are within the area surrounded by boundaries a to f (including points on the boundaries) were set as the IrMn film thickness and the Cu film thickness which could be selected in this embodiment.

By adjusting the IrMn film thickness and the Cu film thickness so as to be within the area surrounded by boundaries a to f, the interlayer coupling magnetic field Hin can be made to be 10 (Oe) or more, and the variation in the interlayer coupling magnetic field Hin can be made to be 2 (Oe) or less. Furthermore, in the area surrounded by boundaries a to f, a Cu film thickness range in which the variation can be made to be 2 (Oe) or less can be set over a wide range at any IrMn film thickness, as compared with the known structure.

Next, Fig. 9 is a graph showing a range of the Cu film thickness in which the interlayer coupling magnetic field Hin was 1 (Oe) higher than the bottom value of the interlayer coupling magnetic field Hin, the range being determined for each of the IrMn film thicknesses using the same experimental results shown in Fig. 8. As expected, when the acceptable range of the variation in the interlayer coupling magnetic field Hin is set to be 1 (Oe), the acceptable range of the Cu film thickness for each IrMn film thickness is narrower than the case shown in Fig. 8. However, when the IrMn film thickness is in the range of 90 Å to 150 Å, the range of the Cu film thickness in which the interlayer coupling magnetic field Hin can be made to be 10 (Oe) or more and the variation in the interlayer coupling magnetic field Hin can be made to be 1 (Oe) or less can be set over a wide range, as compared with the known structure.

As shown in Fig. 9, the Cu film thickness range in which the difference between the maximum value of the interlayer coupling magnetic field Hin and the minimum value of the interlayer coupling magnetic field Hin could be made to be 1 (Oe) or less even when the Cu film thickness was varied in the range was denoted as follows: When the IrMn film thickness was 90 Å, the range was between point G and point J. When the IrMn film thickness was 130 Å, the range was between point H and point K. When the IrMn film thickness was 150 Å, the range was between point I and point L.

Next, the points G to L shown in Fig. 9 were plotted on the graph shown in Fig. 7 in which the horizontal axis represents the IrMn film thickness and the vertical axis represents the Cu film thickness. Point G and point H were joined by a straight line forming boundary g, the point H and point I were joined by a straight line forming boundary h, point J and point K were joined by a straight line forming boundary i, the point K and point L were joined by a straight line forming boundary j, the point G and the point J were joined by a straight line forming boundary k, and the point I and the point L were joined by a straight line forming boundary 1.

By adjusting the IrMn film thickness and the Cu film thickness so as to be within the area surrounded by boundaries g to 1 (including points on the boundaries), the interlayer coupling magnetic field Hin can be made to be 10 (Oe) or more, and the variation in the interlayer coupling magnetic field Hin can be reduced to 1 (Oe) or less. Furthermore, in the area surrounded by boundaries g to 1, an acceptable Cu film thickness range can be set over a wide range at any IrMn film thickness, as compared with the known structure. As shown in Fig. 9, in this embodiment, at least 2 Å or more of the Cu film thickness range could be ensured. In contrast, as is apparent from Fig. 9, in the case where the IrMn film thickness was 60 Å (in the example of a known structure), in order to reduce the variation in the interlayer coupling magnetic field Hin to 1 (Oe) or less within the range in which 10 (Oe) or more of the interlayer coupling magnetic field Hin was obtained, the Cu film thickness range was less than 0.5 Å.

As described above, in this embodiment, the Cu film thickness range in which the interlayer coupling magnetic field Hin is 10 (Oe) or more and the variation in the interlayer coupling magnetic field Hin is 1 (Oe) or less can be set over a wide range, as compared with the known structure. Accordingly, even if a certain degree of error in film deposition is present, a magnetoresistive element which has an interlayer coupling magnetic field Hin of 10 (Oe) or more and a reduced variation in the interlayer coupling magnetic field Hin can be easily and appropriately obtained.

Furthermore, the ratios of change in resistance (ΔR/R) of the plurality of magnetoresistive elements with different Cu film thicknesses and different IrMn film thicknesses used in the experiments shown in Figs. 6 and 7 were measured. Fig. 10 shows the experimental results thereof. In Fig. 10, the horizontal axis represents the Cu film thickness and the vertical axis represents the ratio of change in resistance (ΔR/R).

As shown in Fig. 10, it was found that as the IrMn film thickness increased, the ratio of change in resistance (ΔR/R) decreased. In addition, as the Cu film thickness increased, the ratio of change in resistance (ΔR/R) tended to decrease.

The ratio of change in resistance (ΔR/R) is preferably high because a decrease in the ratio of change in resistance (ΔR/R) decreases the magnetic field detection accuracy. In this embodiment, it was specified that 10% or more of the ratio of change in resistance (ΔR/R) is preferable. As shown in Fig. 10, it was found that when the IrMn film thickness was set to be in the range of 90 Å to 150 Å, 10% or more of the ratio of change in resistance (ΔR/R) could be obtained.

With reference to the tendency shown in Fig. 10, if the IrMn film thickness exceeds 150 Å, it is assumed that the ratio of change in resistance (ΔR/R) decreases and readily becomes 10% or less. Accordingly, in this embodiment, the upper limit of the IrMn film thickness was determined to be 150 Å.

As described above, according to the magnetoresistive element 10 of this embodiment, an interlayer coupling magnetic field Hin of 10 (Oe) or more with a small variation can be easily and appropriately obtained, as compared with the known structure.

A plurality of such magnetoresistive elements 10 are formed on a wafer at the same time. In this embodiment, even when layers cannot be laminated so that the thickness of each of the layers is uniform over the entire surface of the wafer due to a film deposition accuracy of the production process, a plurality of magnetoresistive elements 10 which have an interlayer coupling magnetic field Hin of 10 (Oe) or more and in which the variation in the interlayer coupling magnetic field Hin is small can be produced at the same time. Specifically, for example, when the IrMn film having a thickness of about 90 Å is formed, the Cu film is formed so as to have a thickness between the point A (21.3 Å) and the point D (24.6 Å) inclusive, shown in Fig. 6. In such a case, the variation in the interlayer coupling magnetic field Hin of the magnetoresistive elements 10 can be reduced to 2 (Oe) or less. When the Cu film is formed so as to have a thickness between the point G (21.5 Å) and the point J (23.7 Å) inclusive, shown in Fig. 7, the variation in the interlayer coupling magnetic field Hin of the magnetoresistive elements 10 can be reduced to 1 (Oe) or less. Accordingly, even when the Cu film thickness is varied within a range of about several angstroms in the production, the variation in the interlayer coupling magnetic field Hin of the magnetoresistive elements 10 can be reduced.

In addition, although it depends on the magnitude of the desired interlayer coupling magnetic field Hin, as the IrMn film thickness is increased, an acceptable range of the Cu film thickness in which the variation in the interlayer coupling magnetic field Hin can be reduced to 2 (Oe) or less or 1 (Oe) or less can be increased, thereby improving the yield.

By installing the magnetoresistive element 10 of this embodiment in the magnetic sensor 1, 10 (Oe) or more of the interlayer coupling magnetic field Hin of the magnetoresistive element 10 can be ensured, and thus the resistance does not readily change in response to a disturbance magnetic field other than an external magnetic field generated from the magnet M, thereby improving the operational stability. In addition, since the variation in the interlayer coupling magnetic field Hin of the magnetoresistive elements 10 installed in individual magnetic sensors 1 can be reduced, the variation in the output timing of a magnetic-field detection signal in the magnetic sensors 1 can be reduced.

Furthermore, as shown in Fig. 3, when a bridge circuit including two magnetoresistive elements 10 is incorporated in a single magnetic sensor 1, the interlayer coupling magnetic field Hin of each of the magnetoresistive elements 10 can be made to be 10 (Oe) or more, and the variation in the interlayer coupling magnetic fields Hin can be easily reduced to 2 (Oe) or less, and preferably 1 (Oe) or less. Accordingly, the variation in the change in resistance of the magnetoresistive elements 10 in response to an external magnetic field can be reduced, and thus, magnetic field detection can be performed with excellent operational stability.

A method of producing the magnetoresistive elements 10 of this embodiment will be described below.

First, before the magnetoresistive elements 10 are formed, an integrated circuit 3 and an insulating layer 4 are formed on a wafer.

Next, the layers shown in Fig. 4 and constituting each of the magnetoresistive elements 10 are deposited on the insulating layer 4 by a sputtering method or the like. In this case, the antiferromagnetic layer 51 is made of IrMn and is formed so as to have a thickness in the range of 90 Å to 150 Å. Cu is deposited to form the nonmagnetic interlayer 53. In this step, when the variation in the interlayer coupling magnetic field Hin of the plurality of magnetoresistive elements formed on a substrate is made to be 2 (Oe) or less, the Cu film thickness is determined in accordance with the film thickness of the antiferromagnetic layer 51 using the graph shown in Fig. 6. For example, when the IrMn film thickness is 90 Å, a Cu film thickness between the point A and the point D inclusive, shown in Fig. 6, is selected. In this case, the Cu film is preferably deposited so as to have a thickness of the midpoint between the point A and the point D. When the Cu film thickness at the midpoint between the point A and the point D is selected, the interlayer coupling magnetic field Hin is the bottom value (minimum value) of the curve in which the IrMn film thickness is 90 Å on the graph shown in Fig. 8. As shown in Fig. 8, at any IrMn film thickness, when the Cu film thickness is increased or decreased from the Cu film thickness at the bottom value, the interlayer coupling magnetic field Hin tends to substantially symmetrically increase on the curve. Therefore, when the Cu film is deposited so as to have a thickness at which the interlayer coupling magnetic field Hin is just the bottom value (minimum value), the variation in the interlayer coupling magnetic field Hin can be reduced to a very small value even if a certain degree of error in film deposition is present.

Accordingly, in the deposition of the nonmagnetic interlayer 53 (Cu), it is preferable that the Cu film thickness just at the midpoint in the acceptable Cu film thickness range be selected at each IrMn film thickness within the area surrounded by boundaries a to f shown in Fig. 6 or boundaries g to l shown in Fig. 7.

The laminated structure shown in Fig. 4 is deposited and then processed by etching so as to have the shape of a magnetoresistive element. In this step, a plurality of magnetoresistive elements are formed on the same wafer. Fixed resistance elements 20 and various types of electrodes are also formed.

The wafer is then cut into pieces of the magnetic sensor 1 so that a single magnetoresistive element or a plurality of magnetoresistive elements constitute one unit.

The magnetic sensor 1 of this embodiment can be used for detecting not only the opening and closing of a foldable mobile phone, but also, for example, the opening and closing, rotation, or position of other electronic devices.

### Brief Description of Drawings

[Fig. 1] Fig. 1 is a perspective view showing a magnetic sensor of an embodiment.
[Fig. 2] Fig. 2 is a longitudinal cross-sectional view of the magnetic sensor taken along line II-II of Fig. 1.
[Fig. 3] Fig. 3 is a circuit configuration diagram of the magnetic sensor.
[Fig. 4] Fig. 4 is an enlarged cross-sectional view showing the film structure of a magnetoresistive element (GMR element) of the embodiment cut along the film thickness direction.
[Fig. 5] Fig. 5 is an R-H curve diagram of the magnetoresistive element of the embodiment.
[Fig. 6] Fig. 6 is a first graph for specifying the thickness of an antiferromagnetic layer (IrMn) and the thickness of a nonmagnetic interlayer (Cu) of the magnetoresistive element of the embodiment.
[Fig. 7] Fig. 7 is a second graph for specifying the thickness of the antiferromagnetic layer (IrMn) and the thickness of the nonmagnetic interlayer (Cu) of the magnetoresistive element of the embodiment.
[Fig. 8] Fig. 8 is a graph showing the relationship between the thickness of a Cu film and the interlayer coupling magnetic field in magnetoresistive elements each including an IrMn film having a thickness of 60 Å, 90 Å, 130 Å, or 150 Å, and specifying a range of the Cu film thickness where an interlayer coupling magnetic field Hin that is 2 (Oe) higher than the bottom value (the minimum value) of the interlayer coupling magnetic field Hin is obtained.
[Fig. 9] Fig. 9 is a graph showing the relationship between the thickness of a Cu film and the interlayer coupling magnetic field in magnetoresistive elements each including an IrMn film having a thickness of 60 Å, 90 Å, 130 Å, or 150 Å, and specifying a range of the Cu film thickness where an interlayer coupling magnetic field Hin that is 1 (Oe) higher than the bottom value (the minimum value) of the interlayer coupling magnetic field Hin is obtained;
[Fig. 10] Fig. 10 is a graph showing the relationship between the thickness of a Cu film and the ratio of change in resistance (ΔR/R) in magnetoresistive elements each including an IrMn film having a thickness of 60 Å, 90 Å, 130 Å, or 150 Å.
[Fig. 11] Fig. 11 is a graph showing the relationship between the thickness of a nonmagnetic interlayer (Cu) and the interlayer coupling magnetic field Hin in a known example of a magnetoresistive element including an antiferromagnetic layer (IrMn) having a thickness of 60 Å.

### Reference Numerals

- 1: magnetic sensor
- 2: substrate
- 3: integrated circuit
- 4: insulating layer
- 10: magnetoresistive element
- 17: lead layer
- 20: fixed resistance element
- 32: power supply pad 32
- 33,: 40 active element
- 34: ground pad
- 35: wiring layer
- 37: differential amplifier
- 39: comparator
- 41: output transistor
- 42: output pad
- 51: antiferromagnetic layer (IrMn)
- 52: pinned magnetic layer
- 53: nonmagnetic interlayer (Cu)
- 54: free magnetic layer
- 55: protective layer
- 60: R-H curve
- Hin: interlayer coupling magnetic field

## Claims

1. A magnetoresistive element used in a magnetic sensor, comprising a laminated structure having an antiferromagnetic layer, a pinned magnetic layer which is provided on the antiferromagnetic layer and in which the magnetization direction is pinned, and a free magnetic layer which faces the pinned magnetic layer with a nonmagnetic interlayer provided therebetween and in which the magnetization direction changes in response to an external magnetic field,
wherein the antiferromagnetic layer is composed of IrMn, and the nonmagnetic interlayer is composed of Cu, and
wherein the thickness of the antiferromagnetic layer and the thickness of the nonmagnetic interlayer have values that are within the area surrounded by, on a graph of Fig. 6 in which the horizontal axis represents the IrMn film thickness and the vertical axis represents the Cu film thickness,
boundary a (including points on boundary a) formed by a straight line joining point A (IrMn film thickness, Cu film thickness) = (90 Å, 21.3 Å) and point B (IrMn film thickness, Cu film thickness) = (130 Å, 22.7 Å),
boundary b (including points on boundary b) formed by a straight line joining the point B and point C (IrMn film thickness, Cu film thickness) = (150 Å, 23.5 Å),
boundary c (including points on boundary c) formed by a straight line joining point D (IrMn film thickness, Cu film thickness) = (90 Å, 24.6 Å) and point E (IrMn film thickness, Cu film thickness) = (130 Å, 26.5 Å),
boundary d (including points on boundary d) formed by a straight line joining the point E and point F (IrMn film thickness, Cu film thickness) = (150 Å, 28.2 Å),
boundary e (including points on boundary e) formed by a straight line joining the point A and the point D, and
boundary f (including points on boundary f) formed by a straight line joining the point C and the point F.

2. The magnetoresistive element according to Claim 1,
wherein the thickness of the antiferromagnetic layer and the thickness of the nonmagnetic interlayer have values that are within the area surrounded by, on a graph of Fig. 7 in which the horizontal axis represents the IrMn film thickness and the vertical axis represents the Cu film thickness,
boundary g (including points on boundary g) formed by a straight line joining point G (IrMn film thickness, Cu film thickness) = (90 Å, 21.5 Å) and point H (IrMn film thickness, Cu film thickness) = (130 Å, 23.0 Å),
boundary h (including points on boundary h) formed by a straight line joining the point H and point I (IrMn film thickness, Cu film thickness) = (150 Å, 24.3 Å),
boundary i (including points on boundary i) formed by a straight line joining point J (IrMn film thickness, Cu film thickness) = (90 Å, 23.7 Å) and point K (IrMn film thickness, Cu film thickness) = (130 Å, 26.0 Å),
boundary j (including points on boundary j) formed by a straight line joining the point K and point L (IrMn film thickness, Cu film thickness) = (150 Å, 27.5 Å),
boundary k (including points on boundary k) formed by a straight line joining the point G and the point J, and
boundary 1 (including points on boundary 1) formed by a straight line joining the point I and the point L.

3. A magnetic sensor comprising the magnetoresistive element according to Claim 1 or 2 and an integrated circuit which is connected to the magnetoresistive element and which generates and outputs a magnetic-field detection signal on the basis of a change in the electrical resistance of the magnetoresistive element in response to an external magnetic field.

4. The magnetic sensor according to Claim 3, wherein two of the magnetoresistive elements are provided, and the magnetoresistive elements constitute a bridge circuit together with fixed resistance elements whose electrical resistances do not change in response to the external magnetic field.

5. A method of producing a plurality of magnetoresistive elements on a single substrate by the same film deposition process, the magnetoresistive elements being used in a magnetic sensor, the method comprising:
forming the magnetoresistive elements so as to have a laminated structure having an antiferromagnetic layer, a pinned magnetic layer which is provided on the antiferromagnetic layer and in which the magnetization direction is pinned, and a free magnetic layer which faces the pinned magnetic layer with a nonmagnetic interlayer provided therebetween and in which the magnetization direction changes in response to an external magnetic field,
wherein the antiferromagnetic layer is composed of IrMn, and the nonmagnetic interlayer is composed of Cu, and
wherein the thickness of the antiferromagnetic layer and the thickness of the nonmagnetic interlayer have values that are within the area surrounded by, on a graph of Fig. 6 in which the horizontal axis represents the IrMn film thickness and the vertical axis represents the Cu film thickness,
boundary a (including points on boundary a) formed by a straight line joining point A (IrMn film thickness, Cu film thickness) = (90 Å, 21.3 Å) and point B (IrMn film thickness, Cu film thickness) = (130 Å, 22.7 Å),
boundary b (including points on boundary b) formed by a straight line joining the point B and point C (IrMn film thickness, Cu film thickness) = (150 Å, 23.5 Å),
boundary c (including points on boundary c) formed by a straight line joining point D (IrMn film thickness, Cu film thickness) = (90 Å, 24.6 Å) and point E (IrMn film thickness, Cu film thickness) = (130 Å, 26.5 Å),
boundary d (including points on boundary d) formed by a straight line joining the point E and point F (IrMn film thickness, Cu film thickness) = (150 Å, 28.2 Å),
boundary e (including points on boundary e) formed by a straight line joining the point A and the point D, and
boundary f (including points on boundary f) formed by a straight line joining the point C and the point F.

6. The method of producing magnetoresistive elements according to Claim 5,
wherein the thickness of the antiferromagnetic layer and the thickness of the nonmagnetic interlayer have values that are within the area surrounded by, on a graph of Fig. 7 in which the horizontal axis represents the IrMn film thickness and the vertical axis represents the Cu film thickness,
boundary g (including points on boundary g) formed by a straight line joining point G (IrMn film thickness, Cu film thickness) = (90 Å, 21.5 Å) and point H (IrMn film thickness, Cu film thickness) = (130 Å, 23.0 Å),
boundary h (including points on boundary h) formed by a straight line joining the point H and point I (IrMn film thickness, Cu film thickness) = (150 Å, 24.3 Å),
boundary i (including points on boundary i) formed by a straight line joining point J (IrMn film thickness, Cu film thickness) = (90 Å, 23.7 Å) and point K (IrMn film thickness, Cu film thickness) = (130 Å, 26.0 Å),
boundary j (including points on boundary j) formed by a straight line joining the point K and point L (IrMn film thickness, Cu film thickness) = (150 Å, 27.5 Å),
boundary k (including points on boundary k) formed by a straight line joining the point G and the point J, and
boundary l (including points on boundary l) formed by a straight line joining the point I and the point L.

## Amended claims

### Amended claims under Art. 19.1 PCT

**1.** (Amended) An on-off signal magnetic sensor comprising:
a magnetoresistive element including
an antiferromagnetic layer, a pinned magnetic layer which is in contact with the antiferromagnetic layer and in which the magnetization direction is pinned, and a free magnetic layer which faces the pinned magnetic layer with a nonmagnetic interlayer provided therebetween and in which the magnetization direction changes in response to an external magnetic field,
wherein the antiferromagnetic layer is composed of IrMn, and the nonmagnetic interlayer is composed of Cu, and
the thickness of the antiferromagnetic layer and the thickness of the nonmagnetic interlayer have values that are within the area surrounded by,
on a graph of Fig. 6 in which the horizontal axis represents the IrMn film thickness and the vertical axis represents the Cu film thickness,
boundary a (including points on boundary a) formed by a straight line joining point A (IrMn film thickness, Cu film thickness) = (90 Å, 21.3 Å) and point B (IrMn film thickness, Cu film thickness) = (130 Å, 22.7 Å),
boundary b (including points on boundary b) formed by a straight line joining the point B and point C (IrMn film thickness, Cu film thickness) = (150 Å, 23.5 A),
boundary c (including points on boundary c) formed by a straight line joining point D (IrMn film thickness, Cu film thickness) = (90 Å, 24.6 Å) and point E (IrMn film thickness, Cu film thickness) = (130 Å, 26.5 Å),
boundary d (including points on boundary d) formed by a straight line joining the point E and point F (IrMn film thickness, Cu film thickness) = (150 Å, 28.2 Å),
boundary e (including points on boundary e) formed by a straight line joining the point A and the point D, and
boundary f (including points on boundary f) formed by a straight line joining the point C and the point F; and
an integrated circuit connected to the magnetoresistive element,
wherein when the distance between the magnetoresistive element and means for generating an external magnetic field is reduced and the intensity of an external magnetic field acting on the magnetoresistive element is increased to a predetermined value or more, the electrical resistance of the magnetoresistive element changes, and then the integrated circuit generates and outputs a magnetic-field detection signal on the basis of the change in the electrical resistance.

**2.** (Amended) The on-off signal magnetic sensor according to Claim 1, wherein the thickness of the antiferromagnetic layer and the thickness of the nonmagnetic interlayer have values that are within the area surrounded by,
on a graph of Fig. 7 in which the horizontal axis represents the IrMn film thickness and the vertical axis represents the Cu film thickness,
boundary g (including points on boundary g) formed by a straight line joining point G (IrMn film thickness, Cu film thickness) = (90 Å, 21.5 Å) and point H (IrMn film thickness, Cu film thickness) = (130 Å, 23.0 Å),
boundary h (including points on boundary h) formed by a straight line joining the point H and point I (IrMn film thickness, Cu film thickness) = (150 Å, 24.3 Å),
boundary i (including points on boundary i) formed by a straight line joining point J (IrMn film thickness, Cu film thickness) = (90 Å, 23.7 Å) and point K (IrMn film thickness, Cu film thickness) = (130 Å, 26.0 Å),
boundary j (including points on boundary j) formed by a straight line joining the point K and point L (IrMn film thickness, Cu film thickness) = (150 Å, 27.5 Å),
boundary k (including points on boundary k) formed by a straight line joining the point G and the point J, and
boundary 1 (including points on boundary 1) formed by a straight line joining the point I and the point L.

**3.** (Cancelled)

**4.** (Amended) The on-off signal magnetic sensor according to Claim 1 or 2, wherein the on-off signal magnetic sensor includes two of the magnetoresistive elements, and the magnetoresistive elements constitute a bridge circuit together with fixed resistance elements whose electrical resistances do not change in response to the external magnetic field.

**5.** (Cancelled)

**6.** (Cancelled)

**7.** (Addition) The on-off signal magnetic sensor according to Claim 1, 2, or 4, wherein, in an R-H graph in which the horizontal axis represents an external magnetic field H and the vertical axis represents the resistance value R of the magnetoresistive element, an R-H curve of the magnetoresistive element has a loop portion LP surrounded by a first curve CV1 and a second curve CV2, and the entire loop portion LP appears at a position disposed away from a line of external magnetic field H = 0 (Oe).

**8.** (Addition) The on-off signal magnetic sensor according to Claim 7, wherein an interlayer coupling magnetic field Hin of the magnetoresistive element is 10 (Oe) or more.
